# EUROPEAN PATENT SPECIFICATION

(11) **EP 0 494 782 B1**
(45) Date of publication and mention of the grant of the patent: **23.04.1997**
(21) Application number: 92300190.3
(22) Date of filing: 09.01.1992
(51) Int. Cl.: H01L 21/66, G01R 31/28

(54) **Wafer burn-in and test system and method of making the same**
Prüf- und Einbrennsystem für einen Wafer und Methode für deren Herstellung
Système de test et de vieillissement thermique pour une plaquette semi-conductrice et méthode pour sa fabrication

(30) Priority: 11.01.1991 US 640198
(43) Date of publication of application: 15.07.1992
(73) Proprietor: TEXAS INSTRUMENTS INCORPORATED, Dallas Texas 75265 (US)
(72) Inventor: Chiu, Anthony M., Richardson, Texas 75082 (US)
(74) Representative: Nettleton, John Victor

(56) References cited:
- EP-A- 0 405 586
- EP-A- 0 413 451
- WO-A-82/02603
- WO-A-88/02549
- IBM TECHNICAL DISCLOSURE BULLETIN, vol. 32, no. 6B, November 1989, New York US, pp. 442-443; 'Wafer burn-in isolation circuit'

## Description

### FIELD OF THE INVENTION

This invention relates to the testing and burn-in of semiconductor devices, and more particularly to a system and method of testing and burn-in whole wafers prior to dicing the wafer.

### BACKGROUND OF THE INVENTION

Most MOS semiconductor products require burn-in and testing to avoid field failures due to devices which are faulty when manufactured. Some procedures use stress by probing at elevated voltages to detect and sort faulty chips before packaging and burn-in.

High pin count contact assemblies similar to the ones used in conventional wafer probe systems are not practical due to the difficulty in maintaining good contact with all the bond pads, between 3000 and 6000, during the burn-in period. This period can range from 20 hours to 120 hours. The construction of such high pin count burn-in probes is expensive, if not impossible.

A flexible, reusable contact assembly, fabricated using plating techniques is less expensive than individual pin probes, but this type of contact cannot be used with bare aluminum bond pads due to the natural oxide on aluminum bond pads. A bumping or oxide removal step is generally required of the bond pad before this type contact assembly can be used. This application, however, is very sensitive to contact pressure and deemed impractical.

EP-A-0 405 586 discloses a semiconductor device and method of burning in the same. A semiconductor wafer has a plurality of IC chip regions and a plurality of power supply wiring layers is formed on the wafer. In a first example, the wiring layers are alternately arranged on the dicing line regions between chip regions in the longitudinal direction of the wafer. A circuit (not shown) for generating a signal for controlling chip operation during the burn-in process is formed on chip regions or on dicing line regions. In a second example, the power supply wiring layers are formed on each of the dicing line regions in the longitudinal direction of the wafer.

WO-A-88/02603 discloses a semiconductor wafer and method of testing networks thereon. An array of integrated circuit dice is disposed on a monolithic wafer substrate. The substrate carries two planes or layers of patterned metal to provide two principal levels of interconnection. An insulation layer is placed between the metal layers and also between the lower metal layer and the substrate if the latter is conductive. Connections between the metal layers or between the metal layer and the substrate can be made through via holes in the insulator layer or layers respectively.

The substrate is divided up into special areas used for inner cells, outer cells, signal hook-up area, and power hook-up areas. The cells are intended to host integrated circuit chips and to provide bonding pads for the signal connections between the chips and the substrate. Small chips can share a cell, over-size chips can extend over two or more cells. In order to interconnect all substrate pads with each other in any possibly desired way and also to connect any or all pads to the outside world a set of pad lines and a set of net lines are provided. The set of net lines comprises horizontal net lines placed in a lower layer and vertical net lines placed in an upper layer.

The present invention provides an interconnection system for burn-in and testing of semiconductor devices prior to separation from a semiconductor wafer, comprising:
a semiconductor wafer having a plurality of semiconductor devices thereon, said semiconductor devices being arranged in rows and columns on said semiconductor wafer, each semiconductor device having a plurality of bond pads and a plurality of edges defining the area of the wafer occupied by the semiconductor device;
a first insulator layer formed over said wafer, said first insulator layer having openings over said bond pads;
a first layer of a plurality of conductors on said first insulator layer, each of the plurality of conductors of said first layer overlaying one of said semiconductor devices without extending past said plurality of edges of that semiconductor device and being connected at one end to a bond pad through one of said openings in said first insulator layer and having a via pad at the other end, the plurality of conductors of said first layer extending in the row direction;
a second insulator layer formed over and covering said first layer of a plurality of conductors, said second insulator layer having openings over said via pads;
a second layer of a plurality of conductors on said second insulator layer, each of the plurality of conductors of said second layer being connected to selected ones of said via pads through associated ones of said openings in said second insulator layer; the conductors of said second layer extending in the column direction, the plurality of conductors of said first layer being staggered in length such that each of the plurality of conductors of said second layer connects in parallel respective via pads of each of the semiconductor devices in a given column; and
a plurality of contact test points arranged on said wafer outside the area occupied by the semiconductor devices, each of said contact test points being connected to one of said conductors in said second layer of a plurality of conductors.

The present invention also provides a method of forming an interconnection system to semiconductor devices formed on a wafer for burn-in and testing of the semiconductor devices prior to separation from said semiconductor wafer, said semiconductor devices being arranged in rows and columns on said semiconductor wafer, comprising the steps of:
forming a first insulating layer over the semiconductor wafer and the semiconductor devices formed thereon, each semiconductor device having a plurality of bond pads and a plurality of edges defining the area of the wafer occupied by the semiconductor device, the first insulating layer having openings over each of the bond pads;
depositing a first layer of metal over said first insulating layer and etching said first layer of metal to form a layer of first conductors over said first insulating layer, each of said first conductors overlaying an associated semiconductor device without extending past said plurality of edges of said associated semiconductor device, each of said first conductors being connected at one end to a bond pad on said associated semiconductor device and having a via pad at the other end, the plurality of conductors of said first layer extending in the row direction;
forming a second insulating layer over the layer of first conductors, the second insulating layer having via openings over each of the via pads;
depositing a second layer of metal over said second insulating layer and etching said second layer of metal to form a layer of second conductors on the second insulating layer, each of said second conductors being connected through via openings to associated ones of said via pads, the conductors of said second layer extending in the column direction, the plurality of conductors of said first layer being staggered in length such that each of the plurality of conductors of said second layer connects in parallel respective via pads of each of the semiconductor devices in a given column; and
forming test point contacts on the semiconductor wafer outside the area occupied by the semiconductor devices, each test point contact being connected to one of said second conductors.

In the illustrated embodiment of the present invention, a positive contact is made to every bond pad on each semiconductor on a wafer. A multilayer structure is used.

In the multilayer structure, contacts are formed around the edge of the wafer. A first layer of a plurality of conductors is formed on an insulating layer over the face of the wafer. There is one conductor for each bond pad on each device that is to be tested. A second layer of a metal conductors is formed over the first layer of conductors. The second layer of leads interconnect common bond pads (for example, pin 1 of each device) together, and to a contact on the edge of the wafer. In this way the semiconductor devices on a single column of devices on the wafer are effectively connected in parallel. This burn-in method is extremely useful for memory devices where all the address lines and input lines can be activated simultaneously. The first layer of conductors may be connected to the second layer of conductor through fuse links. These links may later be cut by using a laser to "disconnect" inoperable or shorted devices.

The technical advance represented by the invention as well as the objects thereof will become apparent from the following description of a preferred embodiment of the invention when considered in conjunction with the accompanying drawings, and the novel features set forth in the appended claims.

### BRIEF DESCRIPTION OF THE DRAWINGS

FIGURE 1 illustrates a semiconductor wafer with a plurality of devices formed thereon;
FIGURE 2 shows an enlarged view of three devices on the wafer;
FIGURE 3 shows three devices with a first layer of conductors thereon; and
FIGURE 4 shows the three devices of Figure 3 with a second layer of conductors thereon.

### DESCRIPTION OF A PREFERRED EMBODIMENT

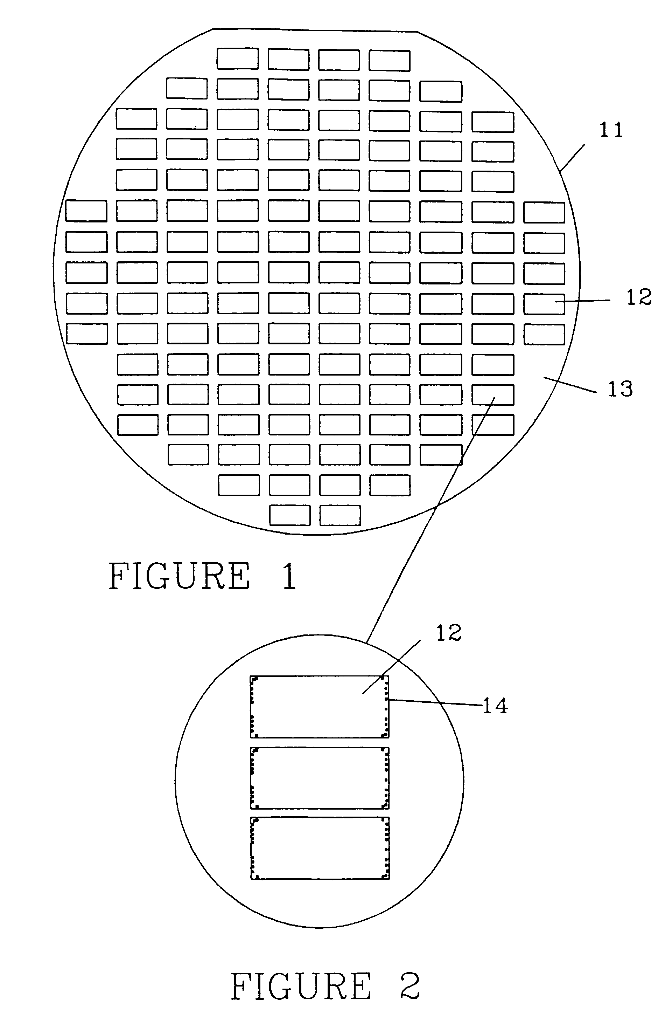

FIGURE 1 illustrates a semiconductor wafer 11 with a plurality of semiconductor devices 12 formed thereon. Wafer 11 has a marginal area 13 around the edge of the wafer that is clear of devices. Test points are formed on the marginal area 13 to provide contact access to the semiconductor devices for testing and burn-in, as herein after described.

Figure 2 is an enlarged view of a portion of wafer 11 showing three semiconductor devices 12 having bond pads 14 thereon. Bond pads 14 are the contact for the device 12.

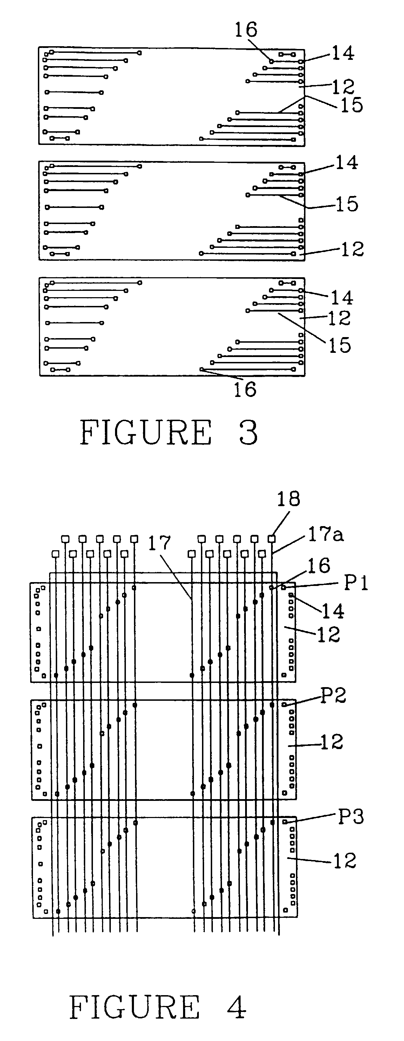

Figure 3 illustrates the first step in providing a connection interface for each of the semiconductor devices 12. A first layer of interconnections are formed on the surface of the wafer, over each individual semiconductor device. The procedure is as follows. An adhesive, such as thermal plastic, is applied over the wafer, and then a dielectric material, such as polyimide, is applied over the adhesive. The dielectric is then patterned to provide an opening over each bond pad 14. A layer of a first metal such as TiW is applied over the dielectric and then a second metal is applied, such as copper. The metal layer is then patterned and etched to form the fuse link conductors 15, exposed conductors that can be cut open later to isolate the shorted devices. Each conductor 15 is connected at one end to a device bond pad 14. On the other end of each conductor 15, opposite the end connected to the device bond pad, is formed via pad 16.

Figure 4 illustrates the second step in providing a connection interface for each semiconductor device on wafer 11. Continuing the process, a dielectric is applied over the wafer, covering conductors 15 and via pads 16. Via patterns are etched on the polyimide. A second layer of metal is applied over the dielectric, for example a layer of TiW followed by a layer of copper. The second layer of metal is patterned and etched to form interconnection conductors 17. The polyimide is also etched during this masking step to expose part of conductors 15 (not illustrated). Each of these conductors connects the via pads on each device in a particular column. For example, a conductor connecting to a via pad is connected by conductor 15 to a respective bond pad on each device. For example, conductor 17a is connected to bond pads P₁, P₂ and P₃ by a respective conductor 15 and via pad 16. Each conductor 17 is connected to a test point 18 located in the non-patterned area 13 of wafer 11.

A preliminary test of the devices on the wafer may have located inoperable devices. The inoperable device is electrically isolated by cutting connector 15 of a device by, for example, a laser beam. After preliminary test, for opens and shorts, the remaining devices are subjected to a burn-in to determine if there are additional defective devices. After burn-in and preliminary test, the two layers of conductors 15 and 17 are removed, and the wafer divided into individual devices for further assembly.

One advantage of the interconnection system of the invention is that preliminary test may be made in parallel prior to dividing the wafer into the individual devices, and that the interconnection may then be removed for final individual device assembly and test. To test devices in wafer form, it is necessary to contact the "output" pin(s) of each device. This is accomplished by the use of a probe card or an additional metal layer that connects the output pins to a more convenient location on the wafer.

## Claims

1. An interconnection system for burn-in and testing of semiconductor devices (12) prior to separation from a semiconductor wafer (11), comprising:
a semiconductor wafer (11) having a plurality of semiconductor devices (12) thereon, said semiconductor devices (12) being arranged in rows and columns on said semiconductor wafer (11), each semiconductor device (12) having a plurality of bond pads (14) and a plurality of edges defining the area of the wafer occupied by the semiconductor device (12);
a first insulator layer formed over said wafer (11), said first insulator layer having openings over said bond pads (14);
a first layer of a plurality of conductors (15) on said first insulator layer, each of the plurality of conductors (15) of said first layer overlaying one of said semiconductor devices (12) without extending past said plurality of edges of that semiconductor device (12) and being connected at one end to a bond pad (14) through one of said openings in said first insulator layer and having a via pad (16) at the other end, the plurality of conductors (15) of said first layer extending in the row direction;
a second insulator layer formed over and covering said first layer of a plurality of conductors (15), said second insulator layer having openings over said via pads (16);
a second layer of a plurality of conductors (17) on said second insulator layer, each of the plurality of conductors (17) of said second layer being connected to selected ones of said via pads (16) through associated ones of said openings in said second insulator layer; the conductors (17) of said second layer extending in the column direction, the plurality of conductors (15) of said first layer being staggered in length such that each of the plurality of conductors (17) of said second layer connects in parallel respective via pads (16) of each of the semiconductor devices (12) in a given column; and
a plurality of contact test points (18) arranged on said wafer (11) outside the area occupied by the semiconductor devices, each of said contact test points (18) being connected to one of said conductors (17) in said second layer of a plurality of conductors (17).

2. A method of forming an interconnection system to semiconductor devices (12) formed on a wafer (11) for burn-in and testing of the semiconductor devices (12) prior to separation from said semiconductor wafer (11), said semiconductor devices (12) being arranged in rows and columns on said semiconductor wafer (11), comprising the steps of:
forming a first insulating layer over the semiconductor wafer (11) and the semiconductor devices (12) formed thereon, each semiconductor device (12) having a plurality of bond pads (14) and a plurality of edges defining the area of the wafer occupied by the semiconductor device (12), the first insulating layer having openings over each of the bond pads (14);
depositing a first layer of metal over said first insulating layer and etching said first layer of metal to form a layer of first conductors (15) over said first insulating layer, each of said first conductors (15) overlaying an associated semiconductor device (12) without extending past said plurality of edges of said associated semiconductor device (12), each of said first conductors (15) being connected at one end to a bond pad (14) on said associated semiconductor device (12) and having a via pad (16) at the other end, the plurality of conductors (15) of said first layer extending in the row direction;
forming a second insulating layer over the layer of first conductors (15), the second insulating layer having via openings over each of the via pads (16);
depositing a second layer of metal over said second insulating layer and etching said second layer of metal to form a layer of second conductors (17) on the second insulating layer, each of said second conductors (17) being connected through via openings to associated ones of said via pads (16), the conductors (17) of said second layer extending in the column direction, the plurality of conductors (15) of said first layer being staggered in length such that each of the plurality of conductors (17) of said second layer connects in parallel respective via pads (16) of each of the semiconductor devices (12) in a given column; and
forming test point contacts (18) on the semiconductor wafer (11) outside the area occupied by the semicondutor devices, each test point contact (18) being connected to one of said second conductors (17).

## Patentansprüche

1. Verbindungssystem zum Einbrennen und Testen von Halbleiter-Vorrichtungen (12) vor dem Abtrennen von einer Halbleiterscheibe (11), enthaltend:
eine Halbleiterscheibe (11) mit mehreren darauf befindlichen Halbleiter-Vorrichtungen (12), wobei die Halbleiter-Vorrichtungen auf der Halbleiterscheibe (11) in zeilen und Spalten angeordnet sind, wobei jede Halbleiter-Vorrichtung (12) mehrere Bondkontaktflächen (14) und mehrere Kanten aufweist, die die von der Halbleiter-Vorrichtung (12) auf der Scheibe besetzte Fläche begrenzen;
eine erste Isolatorschicht auf der Scheibe (11), wobei die erste Isolatorschicht über den Bondkontaktflächen (14) Öffnungen aufweist;
eine erste Schicht aus mehreren Leitern (15) auf der ersten Isolatorschicht, wobei jeder der mehreren Leiter (15) der ersten Schicht über einer der Halbleiter-Vorrichtungen (12) liegt, ohne sich über die mehreren Kanten der Halbleiter-Vorrichtung (12) hinaus zu erstrecken, und an einem Ende mit einer Bondkontaktfläche (14) durch eine der Öffnungen in der ersten Isolatorschicht hindurch verbunden ist und am anderen Ende mit einer Durchkontaktfläche (16) versehen ist, wobei die mehreren Leiter (15) der ersten Schicht in der Zeilenrichtung verlaufen;
eine zweite Isolatorschicht, die über der ersten Schicht aus mehreren Leitern (15) gebildet ist und diese bedeckt, wobei die zweite Isolatorschicht Öffnungen über den Durchkontaktflächen (16) aufweist;
eine zweite Schicht aus mehreren Leitern (17) auf der zweiten Isolatorschicht, wobei jeder der mehreren Leiter (17) der zweiten Schicht jeweils mit ausgewählten Durchkontaktflächen (16) durch zugehörige Öffnungen in der zweiten Isolatorschicht hindurch verbunden ist, wobei die Leiter (17) der zweiten Schicht in der spaltenrichtung verlaufen, wobei die mehreren Leiter (15) der ersten Schicht in der Länge so gestaffelt sind, daß jeder der mehreren Leiter (17) der zweiten Schicht in der Länge so gestaffelt sind, daß jeder der mehreren Leiter (17) der zweiten Schicht jeweilige Durchkontaktflächen (16) jeder der Halbleiter-Vorrichtungen (12) in einer gegebenen Spalte parallel miteinander verbindet; und
mehrere Kontakttestpunkte (18), die auf der Scheibe (11) außerhalb der von den Halbleiter-Vorrichtungen besetzten Fläche angeordnet sind, wobei jeder der Kontakttestpunkte (18) mit einem der Leiter (17) in der zweiten Schicht aus mehreren Leitern (17) verbunden ist.

2. Verfahren zum Herstellen eines Verbindungssystems für Halbleiter-Vorrichtungen (12) auf einer Scheibe (11) zum Einbrennen und Testen der Halbleiter-Vorrichtungen (12) vor dem Abtrennen von der Halbleiterscheibe (11), wobei die Halbleiter-Vorrichtungen (12) auf der Halbleiterscheibe (11) in Zeilen und Spalten angeordnet sind, enthaltend die Schritte:
Bilden einer ersten Isolatorschicht auf der Halbleiterscheibe (11) und den darauf gebildeten Halbleiter-Vorrichtungen (12), wobei jede Halbleiter-Vorrichtung (12) mehrere Bondkontaktflächen (14) und mehrere Kanten aufweist, die die von der Halbleiter-Vorrichtung (12) eingenommene Fläche der Scheibe begrenzen, wobei die erste Isolatorschicht über jede der Bondkontaktflächen (14) Öffnungen aufweist;
Aufbringen einer ersten Metallschicht auf der ersten Isolatorschicht und Ätzen der ersten Metallschicht zur Bildung einer Schicht aus ersten Leitern (15) über der ersten Isolatorschicht, wobei jeder der ersten Leiter (15) über einer zugehörigen Halbleiter-Vorrichtung (12) liegt, ohne über die mehreren Kanten der zugehörigen Halbleiter-Vorrichtung (12) hinauszuragen, wobei jeder der ersten Leiter (15) an einem Ende mit einer Bondkontaktfläche (14) auf der zugehörigen Halbleiter-Vorrichtung (12) verbunden ist und am anderen Ende eine Durchkontaktfläche (16) aufweist, wobei die mehreren Leiter (15) der ersten Schicht in der Zeilenrichtung verlaufen;
Bilden einer zweiten Isolatorschicht auf der Schicht aus den ersten Leitern (15), wobei die zweite Isolatorschicht über jeder der Durchkontaktflächen (16) Durchgangsöffnungen aufweist;
Aufbringen einer zweiten Metallschicht auf der zweiten Isolatorschicht und Ätzen der zweiten Metallschicht zur Bildung einer Schicht aus zweiten Leitern (17) auf der zweiten Isolatorschicht, wobei jeder der zweiten Leiter (17) über Durchgangsöffnungen mit zugehörigen Durchkontaktflächen (16) verbunden ist, wobei die Leiter (17) der zweiten Schicht in der Spaltenrichtung verlaufen, wobei die mehreren Leiter (15) der ersten Schicht in der Länge so gestaffelt sind, daß jeder der mehreren Leiter (17) der zweiten Schicht jeweilige Durchkontaktflächen (16) jeder der Halbleiter-Vorrichtungen (12) in einer gegebenen Spalte parallel schalten; und
Bilden von Testpunktkontakten (18) auf der Halbleiterscheibe (11) zur außerhalb der von den Halbleiter-Vorrichtungen besetzten Fläche, wobei jeder Testpunktkontakt (18) mit einem der zweiten Leiter (17) verbunden ist.

## Revendications

1. Système d'interconnexion pour le vieillissement artificiel et le test de dispositifs à semiconducteurs (12) avant leur séparation d'une tranche semiconductrice (11), comprenant :
une tranche semiconductrice (11) portant une pluralité de dispositifs à semiconducteurs (12), lesdits dispositifs à semiconducteurs (12) étant disposés suivant des lignes et des colonnes sur ladite tranche semiconductrice (11), chaque dispositif à semiconducteurs (12) comportant une pluralité de plots de connexion (14) et une pluralité de bords définissant la zone de la tranche occupée par le dispositif à semiconducteurs (12);
une première couche isolante formée sur ladite tranche (11), ladite première couche isolante comportant des ouvertures au-dessus desdits plots de connexion (14);
une première couche d'une pluralité de conducteurs (15) situés sur ladite première couche isolante, chaque conducteur de la pluralité de conducteurs (15) de ladite première couche recouvrant l'un desdits dispositifs à semiconducteurs (12) sans s'étendre au-delà de ladite pluralité de bords de ce dispositif à semiconducteurs (12) et étant connecté par une extrémité, à un plot de connexion (14) par l'intermédiaire de l'une desdites ouvertures aménagée dans ladite première couche isolante et comportant, au niveau de l'autre extrémité, un plot de connexion traversante (16), la pluralité de conducteurs (15) de ladite première couche s'étendant dans la direction des lignes:
une seconde couche isolante formée sur et recouvrant ladite première couche d'une pluralité de conducteurs (15), ladite seconde couche isolante comportant des ouvertures au-dessus desdits plots de connexion traversante (16);
une seconde couche d'une pluralité de conducteurs (17) sur ladite seconde couche isolante, chaque conducteur de ladite pluralité de conducteurs (17) de ladite seconde couche étant connecté à des plots sélectionnés parmi lesdits plots d'interconnexion traversante (16) au moyen de certaines associées desdites ouvertures situées dans ladite seconde couche isolante; les conducteurs (17) de ladite seconde couche s'étendant dans la direction des colonnes, la pluralité de conducteurs (15) de ladite première couche ayant des longueurs étagées de sorte que chaque conducteur de ladite pluralité de conducteurs (17) de ladite seconde couche connecte en parallèle des plots respectifs d'interconnexion (16) de chacun des dispositifs à semiconducteurs (12) dans une colonne donnée; et
une pluralité de points de contact de test (18) disposés sur ladite tranche (11) à l'extérieur de la zone occupée par les dispositifs à semiconducteurs. chacun desdits points de contact de test (18) étant connecté à l'un desdits conducteurs (17) dans ladite seconde couche d'une pluralité de conducteurs (17).

2. Procédé pour former un système d'interconnexion avec des dispositifs à semiconducteurs (12) formés sur une tranche (11) pour le vieillissement artificiel et le test des dispositifs à semiconducteurs (12), avant leur séparation de ladite tranche semiconductrice (11), lesdits dispositifs à semiconducteurs (12) étant disposés suivant des lignes et des colonnes sur ladite tranche semiconductrice (11), comprenant les étapes consistant à :
former une première couche isolante sur la tranche semiconductrice (11) et les dispositifs à semiconducteurs (12) formés sur cette tranche, chaque dispositif à semiconducteurs (12) possédant une pluralité de plots de connexion (14) et une pluralité de bords définissant la zone de la tranche occupée par le dispositif à semiconducteurs (12), la première couche isolante comportant des ouvertures au-dessus de chacun des plots de connexion (14);
déposer une première couche d'un métal sur ladite première couche isolante et corroder ladite première couche de métal pour former une couche de premiers conducteurs (15) au-dessus de ladite première couche isolante, chacun desdits premiers conducteurs (15) recouvrant un dispositif à semiconducteurs associé (12) sans s'étendre au-delà de ladite pluralité de bords dudit dispositif à semiconducteurs associé (12), chacun desdits premiers conducteurs (15) étant connecté, par une extrémité, à un plot de connexion (14) situé sur ledit dispositif à semiconducteurs associé (12) et comportant, à l'autre extrémité, un plot de connexion traversante (16), la pluralité de conducteurs (15) de la première couche s'étendant dans la direction des lignes;
former une seconde couche isolante sur la couche des premiers conducteurs (15), la seconde couche isolante comportant des ouvertures au-dessus de chacun desdits plots conducteurs de connexion traversante (16);
déposer une seconde couche de métal sur ladite seconde couche isolante et corroder ladite seconde couche de métal pour former une couche de seconds conducteurs (17) sur la seconde couche isolante, chacun desdits seconds conducteurs (17) étant connectés par l'intermédiaire d'ouvertures traversantes à certains associés desdits plots de connexion traversante (16), les conducteurs (17) de ladite seconde couche s'étendant dans la direction des colonnes, la pluralité de conducteurs (15) de ladite première couche ayant des longueurs étagées de sorte que chacun de ladite pluralité de conducteurs (17) de ladite seconde couche connecte en parallèle des plots respectifs de connexion traversante (16) de chacun des dispositifs à semiconducteurs (12) dans une colonne donnée; et
former des contacts de points de test (18) sur la tranche semiconductrice (11) à l'extérieur de la zone occupée par les dispositifs à semiconducteurs, chaque contact de point de test (18) étant connectés à l'un desdits seconds conducteurs (17).
